# EUROPÄISCHE PATENTSCHRIFT

(11) **EP 1 389 307 B1**
(45) Veröffentlichungstag und Bekanntmachung des Hinweises auf die Patenterteilung: **02.07.2008**
(21) Anmeldenummer: 02737806.6
(22) Anmeldetag: 19.04.2002
(51) Int. Cl.: G01P 15/08, G01P 1/02, B81B 7/00, B81B 7/02, B81C 3/00

(54) **SENSORANORDNUNG, INSBESONDERE MIKROMECHANISCHE SENSORANORDNUNG**
SENSOR ARRANGEMENT, IN PARTICULAR MICRO-MECHANICAL SENSOR ARRANGEMENT
ENSEMBLE CAPTEUR, NOTAMMENT ENSEMBLE CAPTEUR MICROMECANIQUE

(30) Priorität: 11.05.2001 DE 10123039
(43) Veröffentlichungstag der Anmeldung: 18.02.2004
(73) Patentinhaber: ROBERT BOSCH GMBH, 70442 Stuttgart (DE)
(72) Erfinder: RUDHARD, Joachim, 70771 Leinfelden-Echterdingen (DE); HEYERS, Klaus, 72766 Reutlingen (DE)
(86) Internationale Anmeldenummer: PCT/DE2002/001452
(87) Internationale Veröffentlichungsnummer: WO 2002/093122

(56) Entgegenhaltungen:
- DE-A- 19 537 814
- DE-A- 19 651 269
- DE-A- 19 820 816
- US-A- 5 831 162
- KNIFFIN M L ET AL: "PACKAGING FOR SILICON MICROMACHINED ACCELEROMETERS" INTERNATIONAL JOURNAL OF MICROCIRCUITS AND ELECTRONIC PACKAGING, INTERNATIONAL MICROELECTRONICS & PACKAGING SOCIETY, US, Bd. 19, Nr. 1, 1996, Seiten 75-86, XP000639470 ISSN: 1063-1674
- PARTRIDGE A ET AL: "New thin film epitaxial polysilicon encapsulation for piezoresistive accelerometers" TECHNICAL DIGEST. MEMS. IEEE INTERNATIONAL CONFERENCE ON MICRO ELECTRO MECHANICAL SYSTEMS, XX, XX, 21. Januar 2001 (2001-01-21), Seiten 54-59, XP002169905

## Beschreibung

### STAND DER TECHNIK

Die vorliegende Erfindung betrifft eine Sensoranordnung, insbesondere eine mikromechanische Sensoranordnung und Verfahren zur Herstellung derselben.

Allgemein sind mikromechanische Sensoren, beispielsweise Drehratensensoren, seit längerem bekannt. Sie bestehen aus einer oder mehreren mikromechanisch strukturierten seismischen Schwingmassen, die einer gesteuerten, periodischen Bewegung (Anregungsbewegungen) in einer Ebene (Anregungsschwingungsebene) unterworfen sind. Die seismischen Schwingmassen sind derart strukturiert und befestigt, dass sie oder Teile derselben in einer Ebene senkrecht zur Anregungsschwingungsebene ebenfalls beweglich aufgehängt sind. Diese Ebene wird als Detektionsebene bestimmt. Dieselben umfassen ferner eine Detektionseinheit, die eine Auslenkung der Schwingmasse bzw. der Schwingmassen oder Teilen derselben in der Detektionsebene aufnimmt. Die Auslenkung in der Detektionsebene kommt entweder aufgrund der Corioliskraft auf die bewegten Schwingmassen bei Linearschwingern oder aufgrund der Drehimpulserhaltung bei Rotationsschwingern zustande.

Ebenfalls bekannt ist die Aufbringung eines Deckel- bzw. Kappenabschnitts auf dem entsprechenden Sensorabschnitt zur Herstellung eines hermetisch abgeschlossenen Sensorinnenraumes zwischen dem Deckelabschnitt und dem Sensorabschnitt. Derartige mikromechanische Sensoren erfordern zur Erzielung einer hohen Güte, das heißt einer geringen Dämpfung der mechanischen Schwingungsstruktur durch ein umgebendes Medium, einen möglichst geringen Gasdruck im unter hermetischem Abschluss verkapselten Sensorinnenraum. Deshalb werden derartige Sensoren i.A. unter Vakuum verkapselt.

Für eine Verbindung von Sensorik und Auswerteelektronik sind verschiedene Ansätze bekannt. Neben einer Verbindung von Sensorabschnitt und Auswerteelektronik via Bonddrähten sind auch integrierte Lösungen, bei denen Elektronik und Sensorik in einem gemeinsamen Herstellungsprozess hergestellt werden, bekannt.

Seit einiger Zeit werden auch additive Integrationen vorgeschlagen, bei denen auf einem fertig prozessierten Elektronikchip mittels eines Niedertemperaturprozesses eine Sensorstruktur, beispielsweise Metalle mittels Galvanik oder Silizium Germanium mittels Niederdruck-Abscheideverfahren aufgebracht werden.

Die zunehmenden Anforderungen an das Auflösungsvermögen der Sensoren und damit an das Signal-Rausch-Verhältnis des Gesamtsystems Sensorabschnitt/Auswerteelektronik erfordert eine Verringerung der parasitären Elemente, die in erheblichem Umfang durch die Zuleitungen und Bondstellen hervorgerufen werden.

Ein Lösungsansatz dieses Problems sieht eine monolithische Integration von Sensorabschnitt und Auswerteelektronik vor. Als nachteilig bei diesem Ansatz hat sich die Tatsache herausgestellt, dass der Sensorprozess wesentlich weniger Maskenebene benötigt als ein komplexer Elektronikprozess. Somit geht ein Teil der Chipoberfläche für die Elektronikfunktion verloren, was schon allein aus Kosten- und Bauraumgründen von Nachteil ist. Zudem besteht der Nachteil, dass Sensorabschnitt und Auswerteelektronik nicht getrennt voneinander prüfbar sind und sich somit die Gesamtausbeute erst auf einem relativ hohen Wertschöpfungslevel prüfen lässt.

Ein alternativer Lösungsansatz besteht in einer additiven Integration von Sensorabschnitt und Auswerteelektronik. Hierbei wird bisher der Sensorabschnitt nachträglich auf eine fertige Auswerteschaltung aufgebracht. Auch durch diesen Ansatz können die parasitären Elemente deutlich reduziert werden. Allerdings können für die Herstellung des Sensors lediglich Niedertemperaturprozesse verwendet werden, um nicht die Elektronik zu schädigen. Zudem hat sich bei diesem Ansatz die Tatsache als nachteilig herausgestellt, dass das Prozessfenster äußerst klein ist und bisher die Darstellung von größeren Bauelementen, wie beispielsweise Drehratensensoren, aufgrund intrinsischer Dämpfungen oder Spannungsgradienten nicht möglich ist.

Zudem weisen alle oben genannten Lösungsansätzen den Nachteil auf, dass die Herstellung des Deckel- bzw. Kappenabschnitts mit einem großen Fertigungsaufwand und somit hohen Fertigungskosten verbunden ist.

Der in der US-Patentschrift US-A-5 831 162 offenbarte Stand der Technik lehrt eine mikromechanische Sensoranordnung, bei der eine Auswerteelektronikeinrichtung in einen Deckelabschnitt integriert ist. Die Schrift KNIFFIN M L ET AL: "Packaging for silicon micromachined accelerometers", INTERNATIONAL JOURNAL OF MICROCIRCUITS AND ELECTRONIC PACKAGING, INTERNATIONAL MICROELECTRONICS & PACKAGING SOCIETY, US, Bd. 19, Nr. 1, 1996, Seiten 75-86, XP000639470 sowie die deutsche Patentanmeldung DE 196 51 269 A zeigen in additivem Schichtaufbau aufgebrachte Deckelabschnitte in mikromechanischen Sensoren.

### VORTEILE DER ERFINDUNG

Die erfindungsgemäße Sensoranordnung mit den Merkmalen des Anspruchs 1 und das entsprechende Herstellungsverfahren mit den Merkmalen von Anspruch 8 weisen gegenüber den bekannten Lösungsansätzen den Vorteil auf, dass sowohl eine kosten- als auch bauraumgünstige Verbindung von Sensorik und Auswerteelektronik durch Integration der Auswerteelektronik zumindest teilweise in den sowieso notwendigen Deckelabschnitt geschaffen wird. Der Herstellungsaufwand ist durch die Integration in den Deckelabschnitt verringert, da eine zusätzliche Aufbringung der Auswerteelektronik auf dem Sensorabschnitt entfällt. Die gesamte Anordnung ist zudem kompakter und bauraumgünstiger ausgebildet.

Gleichzeitig entstehen kurze und reproduzierbare Wege der parasitären Verbindungselemente, wodurch Störungen, die teilweise nach dem Stand der Technik auch größer als das eigentliche Messsignal sein konnten, deutlich verringerbar sind.

Die der vorliegenden Erfindung zugrundeliegende Idee besteht darin, dass eine Auswerteelektronikeinrichtung zumindest teilweise in den Deckelabschnitt für eine Auswertung der Signale des Sensorabschnitts integrierbar und elektrisch mit einer entsprechenden Schaltungseinrichtung des Sensorabschnitts verbindbar ist.

Dadurch erlangt der Deckelabschnitt eine Mehrfachfunktion. Zum einen werden die empfindlichen mikromechanischen Strukturen im Sensorinnenraum vor Messsignal verfälschenden Staubpartikeln oder dergleichen geschützt und ein hermetisch abgeschlossener Bereich für die Erzeugung eines Niederdruckbereiches hergestellt. Zum anderen dient der Deckelabschnitt zumindest teilweise als Träger der Auswerteelektronik, die in dem Deckelabschnitt integrierbar ist.

Der Deckelabschnitt ist als in dem Herstellungsprozess der Sensoranordnung integrierter Schritt, beispielsweise als Dünn - schichtabschnitt auf den Sensorabschnitt, aufbringbar, wobei bereits anfänglich ein einteiliges Bauteil entsteht. In diesem Fall ist der Deckelabschnitt vorzugsweise aus Poly-Silizium oder Poly-Silizium-Germanium ausgebildet.

In den entsprechenden abhängigen Ansprüchen finden sich vorteilhafte Weiterbildungen und Verbesserungen der in Anspruch 1 angegebenen Sensoranordnung und des in Anspruch 8 angegebenen Verfahrens zur Herstellung derselben.

Gemäß einer bevorzugten Weiterbildung ist in dem Sensorinnenraum ein gegenüber dem Atmosphärendruck reduzierter Druck vorgesehen. Dies ist für eine optimierte Funktionsweise der mikromechanischen Sensoranordnung vorteilhaft.

Gemäß einer weiteren bevorzugten Weiterbildung ist die zumindest teilweise in den Deckelabschnitt integrierte Aus-werteelektronikeinri-chtung auf der dem Sensorinnenraum -gegenüber liegenden Oberfläche des Deckelabschnitts vorgesehen.

Gemäß einer weiteren bevorzugten Weiterbildung weist der in den Deckelabschnitt integrierte Teil der Auswerteelektronikeinrichtung eine Signalkonditionierung auf, die eine einfache Ankopplung der Sensoranordnung an weitere Schaltungseinrichtungen, beispielsweise CMOS-Schaltungen, ermöglicht. Jedoch ist eine Inte.grati-on an anderer Stelle ebenfalls vorstellbar.

Gemäß einer weiteren bevorzugten Weiterbildung ist die elektrische Verbindung der Auswerteelektronikeinrichtung des Deckelabschnitts mit der Schaltungseinrichtung des Sensorabschnittes durch mindestens eine Durchkontaktierung, beispielsweise durch eine Grabenstruktur bzw. einen Tiefen-Trench, herstellbar.

### ZEICHNUNGEN

Es zeigen:
- Fig. 1: eine Querschnittsansicht einer Hälfte einer berkömmlichen Sensoranordnung, wobei die Anordnung bezüglich der Ebene A-A' symmetrisch ist; und
- Fig. 2: eine Querschnittsansicht einer Hälfte einer Sensoranordnung gemäß einem Ausführungsbeispiel der vorliegenden Erfindung, wobei die Anordnung bezüglich der Ebene A-A' symmetrisch ist.

### BESCHREIBUNG EINES AUSFÜHRUNGSBEISPIELS

In den Figuren bezeichnen gleiche Bezugszeichen gleiche oder funktionsgleiche Komponenten.

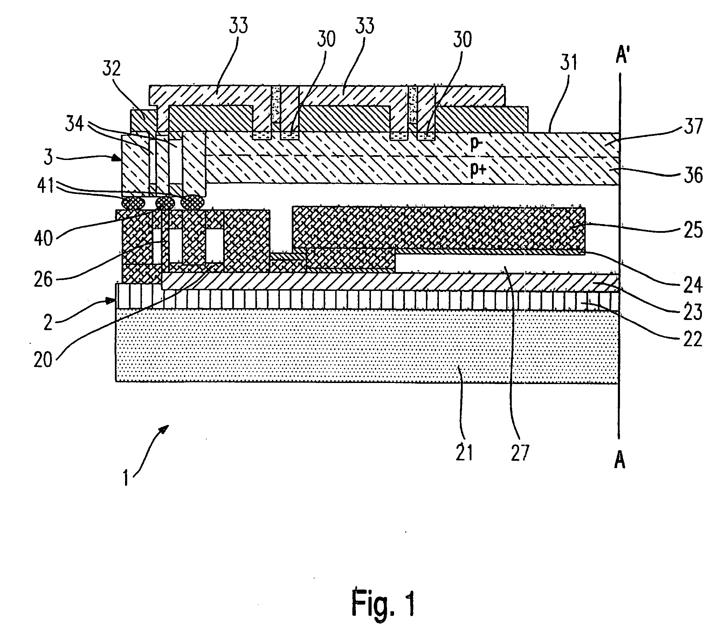

Figur 1 illustriert eine Querschnittsansicht einer herkömmlichen Sensoranordnung 1 wobei lediglich die linke Hälfte der bezüglich der Ebene A-A' symmetrischen Sensoranordnung 1 dargestellt ist.

Diese herkömmliche Sensoranordnung 1 besteht aus einem Sensorabschnitt 2 und einem separaten Deckelabschnitt 3.

Der Sensorabschnitt 2 enthält die eigentliche mikromechanische Sensorstruktur, die in an sich bekannter Weise hergestellt wird. Dabei wird vorteilhaft auf einem Substrat 21, beispielsweise einem Siliziumsubstrat 21, eine Isolationsschicht 22, beispielsweise eine Oxidschicht 22, ganzflächig aufgewachsen. Darauf wiederum wird eine n-Buried-Schicht (vergrabene Schicht) 23 auf der Oxidschicht 22 ganzflächig abgeschieden, die daraufhin beispielsweise durch Ätzen für eine vorbestimmte Leitfähigkeit strukturierbar ist. Über der n-Buried-Schicht 23 wird eine weitere Isolationsschicht 27 vorgesehen, die in der Darstellung gemäß Figur 1 jedoch nicht mehr vorhanden und durch den unteren weißen, horizontal verlaufenden Abschnitt dargestellt ist, da sie im weiteren Herstellungsprozess teilweise weggeätzt wurde. Auf dieser Isolationsschicht 27 werden bestimmte Halbleiterschichten 24, 25, beispielsweise dotiertes polykristalline Silizium-Schichten, aufgebracht.

Mittels entsprechender und an sich bekannter Herstellungsschritte kann die in Figur 1 dargestellte Struktur hergestellt werden, wobei in dem ersten Ausführungsbeispiel eine vergrabene Kontaktierung 26 für eine elektrische Verbindung der elektrischen Schaltungseinrichtung 20 des Sensorabschnitts 2 mit dem noch zu erläuternden Deckelabschnitt 3 hergestellt ist.

Die eigentlich funktionale Sensorschicht ist die beispielsweise in einem Epitaxiereaktor abgeschiedene Poly-Silizium-Schicht 25. Es sind auch andere Halbleiterschichten, wie beispielsweise Silizium-Germanium-Schichten, vorstellbar. Diese frei bewegliche Sensorstruktur ist mittels entsprechender Schaltungseinrichtungen 20 mit der Brückenkontaktierung 26 verbunden.

Vorteilhaft wird ein zweiter Wafer als Sensorwafer bzw. Deckelabschnitt 3 prozessiert. Auf dessen Oberfläche 31 wird zunächst durch Standardprozesse der Halbleitertechnik ein Teil der Auswerteelektronik 30, beispielsweise in Form eines Operationsverstärkers zur Signalkonditionierung, hergestellt. Die Art des Herstellungsprozesses ist beliebig ausführbar und nicht an irgendwelche Bedingungen des Sensorprozesses, geknüpft. Lediglich wird vor der Herstellung der letzten Metallisierungsschicht 33 eine Durchkontaktierung 32, beispielsweise mittels einer Grabenstruktur bzw. eines Tiefen-Trenches, durchgeführt. Dabei dienen die Gräben 34 als Trenchisolationsgräben.

Vorteilhaft wird für die Herstellung der Durchkontaktierung 32 die Waferdicke für eine Reduzierung der Prozesszeiten verringert. Bei Waferdurchmessern von etwa 6" sind Schichtdicken von etwa 180 µm technisch realisierbar.

Die Durchkontaktierung kann auf mehrere Arten erfolgen. Beispielsweise wird ein Wafer 36 aus einem hoch dotierten Siliziummaterial verwendet, auf dem zur Realisierung der Auswerteelektronikeinrichtung 30 eine Epitaxie-Schicht 37 mit einer passend geringen Dotierung aufgebracht wird. Denn für möglichst geringe Störgrößen sind die Durchkontaktierungen 32 möglichst klein zu halten, da der spezifische Widerstand somit ebenfalls einen geringeren Wert annimmt. Für einen solchen geringspezifischen Widerstand ist ein hochdotiertes, gutleitendes Halbleitermaterial 36 zu verwenden, jedoch benötigen bestimmte Auswerteelektronikeinrichtungen 30, beispielsweise Transistoren oder dergleichen, eher einen gering dotierten Träger mit einem erhöhten Widerstand.

Durch die oben beschriebene Struktur aus der hoch dotierten Waferschicht 36 und der eher gering dotierten EpitaxieSchicht 37 können somit direkt durch freistehende Säulen bzw. Brücken 32 Durchkontaktierungen 32 geschaffen werden, die von der Umgebung durch Trenchisolation bzw. Gräben 34 getrennt sind. Dabei sind die Trenchgräben 34 zur Reduzierung parasitärer Kapazitäten relativ groß zu wählen. Allerdings ist ihre Größe wiederum zum Ermöglichen eines Verschlusses, beispielsweise durch Deposition eines Oxids, technisch vernünftig auf eine Ausdehnung von etwa 4 µm bis 5 µm beschränkt.

Aufgrund der oben beschriebenen Geometrien sind die zu erwartenden parasitären Kapazitäten aufgrund der geringeren Ausdehnung um mindestens einen Faktor 20 bis 30 kleiner als die der üblichen Drahtbond-Verbindungen.

Vorteilhaft kann zur Vergrößerung des Abstandes zwischen dem Deckelabschnitt 3 und dem Sensorabschnitt 2 unterhalb des Bereiches der beweglichen Strukturen eine Aussparung eingeätzt werden.

Für eine Verbindung des Sensorabschnitts 2 und des Deckelabschnitts 3 werden an einem der beiden Abschnitte 2, 3 an geeigneter Stelle Kontaktstellenstrukturen 40, beispielsweise.Aluminiumstrukturen 40, mit typischen Dicken von etwa 2 µm aufgebracht. Diese Kontaktstellenstrukturen 40 werden im Bereich der Kontaktierung vorteilhaft punktuell ausgeführt.

Zur hermetischen Abdichtung des Sensorinnenraumes 4 wird zusätzlich außerhalb der Kontaktstruktur 40 eine Dichtung 41, beispielsweise ein geschlossener Aluminium-Ring 41, vorgesehen.

Die beiden Abschnitte 2, 3 werden gegeneinander justiert zusammengefügt und bei Temperaturen von über 500°C unter Niederdruck getempert. Hierdurch diffundiert das Aluminium der Kontaktstellenstrukturen 40 in die Kontaktschichten und bildet somit eine feste Verbindung zwischen den beiden Abschnitten 2, 3.

Alternativ sind auch andere niedrig schmelzende Metalle, z.B. Gold, Zink etc., verwendbar.

Abschließend erfolgt eine Kontaktierung der Durchkontaktierungssäulen 32 auf dem Deckelabschnitt 3 mit der Auswerteelektronikeinrichtung 30 durch die letzte Metallisierungsschicht 33 des Elektronikprozesses.

Somit ist über die vergrabene Kontaktierung 26 des Sensorabschnitts 2, die Kontaktstellenstruktur 40 und die Durchkontaktierung 32 des Deckelabschnitts 3 eine elektrische Verbindung der entsprechenden elektrischen Schaltung des Sensorabschnitts 2 mit der Auswerteelektronik 30 des Deckelabschnitts 3 hergestellt.

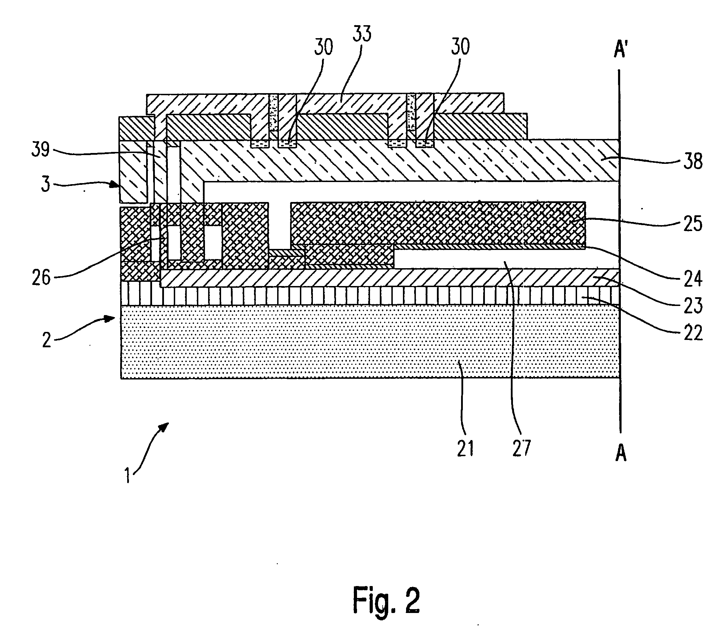

Figur 2 zeigt eine Querschnittsansicht einer Sensoranordnung 1 gemäß einem Ausführungsbeispiel der vorliegenden Erfindung, wobei lediglich die linke Hälfte der bezüglich der Ebene A-A' symmetrischen Sensoranordnung 1 dargestellt ist.

Nicht näher erläuterte Komponenten und deren Funktionen entsprechen denen des oben ausführlich erläuterten Beispiels einer und bedürfen daher hier keiner weiteren Erläuterung.

Im Gegensatz zur herkömmlichem Sensoranordnung besteht die erfindungsgemäße, Sensoranordnung 1 nicht aus zwei separaten Abschnitten 2, 3, sondern die Aufbringung des Deckelabschnitts 3 auf dem Sensorabschnitt 2 erfolgt in einer einheitlich durchgeführten Herstellungsabfolge der gesamten Sensoranordnung 1, wodurch ohne zusätzlichen Verbindungsmitteln eine einteilige Sensorenanordnung 1 durch einen weiterführenden Schichtaufbau hergestellt wird.

Der Bereich, der dem Sensorabschnitt 2 der herkömmlichem Sensoranordnung entspricht, wird analog zu diesem hergestellt und bedarf daher keiner weiteren Erläuterung.

Im Gegensatz zur herkömmlichem Sensoranordnung wird nun eine Isolationsschicht auf dem Sensorabschnitt 2 aufgebracht, die durch Wegätzen den in Figur 2 oberen horizontal verlaufenden Freiraum erzeugt. Dabei liegt die Isolationsschicht über der strukturierten, jedoch noch nicht freigelegten Sensorstruktur des Sensorabschnitts 2, wobei sie vorteilhaft aus demselben Material wie die andere Isolationsschicht 22 besteht.

Die Isolationsschicht ist derart strukturiert, dass an geeigneten Stellen Durchkontaktierungen 39 in an sich bekannter Weise erzeugbar sind.

Anschließend wird auf der Isolationsschicht eine Halbleiterschicht 38, beispielsweise eine Poly-Silizium-Schicht oder Poly-Silizium-Germanium-Schicht 38, aufgebraucht, die als Deckelabschnittsschicht 3 dienen soll. Die Poly-Silizium-Schicht 38 wird an bestimmten Stellen mit Durchgängen versehen (nicht dargestellt), durch die ein Ätzmedium zur Entfernung der Isolationsschicht sowie der Reaktanten eingebracht werden kann.

Abschließend erfolgt ein hermetischer Verschluss des Sensorinnenraums 4 zwischen dem Sensorabschnitt 2 und der Poly-Silizium-Schicht 38 durch Deposition einer Dünnschicht unter Niederdruck. Somit erhält man optimierte Voraussetzungen für die Funktion des mikromechanischen Sensors.

Analog zur herkömmlichem Sensoranordnung wird vorteilhaft in die Oberfläche 31 des Deckelabschnitts 3 zumindest ein Teil einer Auswerteelektronikeinrichtung 30 integriert. Hier handelt es sich jedoch um Bauelemente vorteilhaft in polykristallinen Material, das sich durch entsprechend modifizierte Ladungstransport-, Dotierstofftransport- und MOS-Eigenschaften auszeichnet. Die Eigenschaften dieser Bauelemente sind vergleichbar oder sogar besser als die einer TFT-Elektronik und somit für eine Darstellung elementarer Analogfunktionen ausreichend.

Die Kontaktierung dieser Schaltungselemente mit dem darunter liegenden Sensorabschnitt 2 erfolgt ebenfalls analog zum ersten Ausführungsbeispiel. Allerdings sind die Dicken der Poly-Silizium-Schichten 25, 38 vergleichsweise derart gering, dass der Widerstand der Leiterbahnen weiter verringerbar ist. Zudem wird eine Verbindung direkt während der Abscheidung gewährleistet und die Kontaktierung durch lithographisch erzeugte Kontaktfenster ermöglicht, was zu einer weiteren Störgrößen- und Bauformreduzierung beiträgt.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

So sind die hier aufgeführten Halbleitermaterialien lediglich beispielhaft und keinesfalls abschließend zu verstehen, entscheidend ist lediglich, dass die ausgewählten Materialien die oben erwähnten Eigenschaften aufweisen und gegeneinander vertragbar für eine Ausführung der einzelnen Prozessschritte sind.

## Patentansprüche

1. Sensoranordnung (1), insbesondere mikromechanische Sensoranordnung (1), mit:
- einem Sensorabschnitt (2) zum Liefern bestimmter Sensorsignale,
- einem Deckelabschnitt (3), der auf dem Sensorabschnitt (2) zum Bilden eines hermetisch abgeschlossenen Sensorinnenraumes (4) angeordnet ist, wobei eine Auswerteelektronikeinrichtung (30) zumindest teilweise in dem Deckelabschnitt (3) für eine Auswertung der Sensorsignale integrierbar und elektrisch mit einer entsprechenden Schaltungseinrichtung (20) des Sensorabschnitts (2) verbindbar ist,
**dadurch gekennzeichnet, dass**
- der Deckelabschnitt (3) als Dünnschichtabschnitt (3) auf dem Sensorabschnitt (2) aufgebracht ist.

2. Sensoranordnung nach Anspruch 1, **dadurch gekennzeichnet, dass** in dem Sensorinnenraum (4) ein gegenüber dem Atmosphärendruck reduzierter Druck herstellbar ist.

3. Sensoranordnung nach einem der Ansprüche 1 oder 2, **dadurch gekennzeichnet, dass** die in den Deckelabschnitt (3) zumindest teilweise integrierte Auswerteelektronikeinrichtung (30) auf der dem Sensorinnenraum (4) gegenüberliegenden Oberfläche (31) des Decke-labschnitts. (3) vorgesehen ist.

4. Sensoranordnung nach einem der vorhergehenden Ansprüche, **dadurch gekennzeichnet, dass** der in dem Deckelabschnitt (3) integrierte Teil der Auswerteelektronikeinrichtung (30) eine Signalkonditionierung aufweist, die eine einfache Ankopplung der Sensoranordnung (1) an entsprechende externe Schaltungseinrichtungen,beispielsweise CMOS-Schaltungen, ermöglicht.

5. Sensoranordnung nach einem der vorhergehenden Ansprüche, **dadurch gekennzeichnet, dass** die elektrische Verbindung der Auswerteelektronikeinrichtung (30) und des Deckelabschnitts (3) mit der Schaltungseinrichtung (20) des Sensorabschnitts (2) durch mindestens eine Durchkontaktierung (32, 39), beispielsweise mittels einer Grabenstruktur, herstellbar ist.

6. Sensoranordnung nach einem der vorhergehenden Ansprüche, **dadurch gekennzeichnet, dass** der Deckelabschnitt (3) mit dem Sensorabschnitt (2) mittels Kontaktstellenstrukturen .(40), insbesondere punktuelle Aluminium-Strukturen (40), verbindbar ist.

7. Sensoranordnung nach Anspruch 1, **dadurch gekennzeichnet, dass** der Deckelabschnitt (3) vorzugsweise aus Poly-silizium oder Poly-Silizium-Germanium ausgebildet ist.

8. Verfahren zur Herstellung einer Sensoranordnung (1), insbesondere einer mikromechanischen Sensoranordnung (1), die nach einem der Ansprüche 1 bis 5 ausgebildet ist, mit folgenden Schritten:
Herstellen eines strukturierten Sensorabschnitts (2); Aufbringen einer Isolationsschicht (27) auf dem Sensorabschnitt (2);
Herstellen von Durchkontaktierungen (39) in der Isolationsschicht (27);
Aufbringen einer Deckelabschnittsschicht (3) auf der Isolationsschicht (27);
Entfernen der Isolationsschicht (27);
Bilden eines hermetisch abgeschlossenen Sensorinnenraums (4) zwischen dem Sensorabschnitt (2) und der Deckelabschnittsschicht (3); und
Integrieren einer Auswerteelektronikeinrichtung (30) zumindest teilweise in die Deckelabschnittsschicht (3), die über die Durchkontaktierungen (39) an eine ent-sprechenda. Schaltungseinrichtung (20) des Sensorabschnitts (2) angeschlossen wird.

9. Verfahren nach Anspruch 8, **dadurch gekennzeichnet, dass** die Herstellung der Deckelabschnittsschicht (3), insbesondere als Dünnschichtabschnitt (3) auf dem Sensorabschnitt (2), in dem Herstellungsprozess einer einteiligen Sensoranordnung (1) integriert wird.

10. Verfahren nach einem der Ansprüche 8, oder 9, **dadurch gekennzeichnet, dass** die Deekslabschnitts$chicht (3) vorzugsweise aus Poly-Silizium oder Poly-Silizium-Germanium ausgebildet wird.

11. Verfahren nach einem der Ansprüche 8 bis 10, **dadurch gekennzeichnet, dass** in dem Sensorinnenraum (4) ein gegenüber dem Atmosphärendruck reduzierter Druck vorgesehen wird.

12. Verfahren nach einem der Ansprüche 8 bis 11, **dadurch gekennzeichnet, dass** die in dem Deckelabschnitt (3) zumindest teilweise integrierte Auswerteelektronikeinrichtung (30) auf der dem Sensorinnenraum (4) gegenüberliegenden Oberfläche (31) des Deckelabschnitts (3) vorgesehen wird.

13. Verfahren nach einem der Ansprüche 8 bis 12, **dadurch gekennzeichnet, dass** der in den Deckelabschnitt (3) integrierte Teil der Auswerteelektronikeinrichtung (30) eine Signalkonditionierung aufweist, durch die eine einfache Ankopplung der Sensoranordnung (1) an entsprechende externe Schaltungseinrichtungen, beispielsweise CMOS-Schaltungen, ermöglicht wird.

14. Verfahren nach einem der Ansprüche 8 bis 13, **dadurch gekennzeichnet, dass** die elektrische Verbindung der Auswerteelektronikeinrichtungen (30) des Deckelabschnitts (3) mit der Schaltungseinrichtung (20) des Sensorabschnitts (2) durch mindestens eine Durchkontaktierung (32, 39), beispielsweise mittels einer Grabenstruktur oder Silizium-Säulen, hergestellt wird.

## Claims

1. Sensor arrangement (1), in particular micromechanical sensor arrangement (1), having:
- a sensor section (2) for providing particular sensor signals,
- a cover section (3) which is arranged on the sensor section (2) so as to form a hermetically sealed inner sensor chamber (4), an evaluation electronic device (30) being able to be at least partially integrated in the cover section (3) for the purpose of evaluating the sensor signals and being able to be electrically connected to a corresponding circuit device (20) of the sensor section (2),
**characterized in that**
- the cover section (3) is applied to the sensor section (2) in the form of a thin-film section (3).

2. Sensor arrangement according to Claim 1, **characterized in that** a pressure which is reduced in comparison with atmospheric pressure can be established in the inner sensor chamber (4).

3. Sensor arrangement according to either of Claims 1 and 2, **characterized in that** the evaluation electronic device (30) which is at least partially integrated in the cover section (3) is provided on that surface (31) of the cover section (3) which is opposite the inner sensor chamber (4).

4. Sensor arrangement according to one of the preceding claims, **characterized in that that** part of the evaluation electronic device (30) which is integrated in the cover section (3) has a signal conditioning unit which makes it possible to easily couple the sensor arrangement (1) to corresponding external circuit devices, for example CMOS circuits.

5. Sensor arrangement according to one of the preceding claims, **characterized in that** the evaluation electronic device (30) of the cover section (3) can be electrically connected to the circuit device (20) of the sensor section (2) using at least one plated-through hole (32, 39), for example using a trench structure.

6. Sensor arrangement according to one of the preceding claims, **characterized in that** the cover section (3) can be connected to the sensor section (2) using contact point structures (40), in particular aluminium structures (40) at certain points.

7. Sensor arrangement according to Claim 1, **characterized in that** the cover section (3) is preferably formed from polysilicon or polysilicon/germanium.

8. Method for producing a sensor arrangement (1), in particular a micromechanical sensor arrangement (1), which is designed according to one of Claims 1 to 5, said method having the following steps of:
producing a patterned sensor section (2);
applying an insulation layer (27) to the sensor section (2);
producing plated-through holes (39) in the insulation layer (27);
applying a cover section layer (3) to the insulation layer (27);
removing the insulation layer (27);
forming a hermetically sealed inner sensor chamber (4) between the sensor section (2) and the cover section layer (3); and
at least partially integrating an evaluation electronic device (30) in the cover section layer (3), said device being connected to a corresponding circuit device (20) of the sensor section (2) by means of the plated-through holes (39).

9. Method according to Claim 8, **characterized in that** the production of the cover section layer (3), in particular in the form of a thin-film section (3) on the sensor section (2), is integrated in the process of producing a one-part sensor arrangement (1).

10. Method according to either of Claims 8 and 9, **characterized in that** the cover section layer (3) is preferably formed from polysilicon or polysilicon/germanium.

11. Method according to one of Claims 8 to 10, **characterized in that** a pressure which is reduced in comparison with atmospheric pressure is provided in the inner sensor chamber (4).

12. Method according to one of Claims 8 to 11, **characterized in that** the evaluation electronic device (30) which is at least partially integrated in the cover section (3) is provided on that surface (31) of the cover section (3) which is opposite the inner sensor chamber (4).

13. Method according to one of the one of Claims 8 to 12, **characterized in that that** part of the evaluation electronic device (30) which is integrated in the cover section (3) has a signal conditioning unit which makes it possible to easily couple the sensor arrangement (1) to corresponding external circuit devices, for example CMOS circuits.

14. Method according to one of Claims 8 to 13,
**characterized in that** the evaluation electronic device (30) of the cover section (3) is electrically connected to the circuit device (20) of the sensor section (2) using at least one plated-through hole (32, 39), for example using a trench structure or silicon columns.

## Revendications

1. Dispositif de capteur (1), notamment dispositif de capteur micromécanique (1) comportant
- un segment de capteur (2) pour fournir des signaux de capteur, déterminés,
- un segment de couvercle (3) installé sur le segment de capteur (2) pour former un volume intérieur de capteur (4) fermé hermétiquement, une électronique d'exploitation (30) pouvant être intégrée au moins en partie dans le segment de couvercle (3) pour une exploitation des signaux de capteur, et cette électronique pouvant être reliée électriquement à une installation de commutation (20) correspondante du segment de capteur (2),
**caractérisé en ce que**
le segment de couvercle (3) est réalisé sous la forme d'un segment en couche mince (3) sur le segment de capteur (2).

2. Dispositif de capteur selon la revendication 1,
**caractérisé en ce que**
dans le volume intérieur (4) du capteur on établit une pression réduite par rapport à la pression atmosphérique.

3. Dispositif de capteur selon l'une des revendications 1 ou 2,
**caractérisé en ce que**
l'installation électronique d'exploitation (30) intégrée au moins en partie dans le segment de couvercle (3) est prévue sur la surface (31) du segment de couvercle (3) à l'opposé du volume intérieur (4) du capteur.

4. Dispositif de capteur selon l'une des revendications précédentes,
**caractérisé en ce que**
la partie de l'installation électronique d'exploitation (30) intégrée dans le segment de couvercle (3) comporte un conditionnement de signal permettant un couplage simple du dispositif de capteur (1) sur les installations de commutation externes correspondantes, par exemple des circuits CMOS.

5. Dispositif de capteur selon l'une des revendications précédentes,
**caractérisé en ce que**
la liaison électrique entre l'installation électronique d'exploitation (30) et le segment de couvercle (3) avec l'installation de commutation (20) du segment de capteur (2) est réalisée par au moins un contact traversant (32, 39) par exemple par une structure enfouie.

6. Dispositif de capteur selon l'une des revendications précédentes,
**caractérisé en ce que**
le segment de couvercle (3) peut être relié au segment de capteur (2) à l'aide de structures de position de contact (40), notamment de structures ponctuelles (40) en aluminium.

7. Dispositif de capteur selon la revendication 1,
**caractérisé en ce que**
le segment de couvercle (3) est réalisé de préférence en polysilicium ou en polysilicium-germanium.

8. Procédé de fabrication d'un dispositif de capteur (1), notamment d'un dispositif de capteur micromécanique (1) réalisé selon l'une des revendications 1 à 5 avec les étapes suivantes :
- réalisation d'un segment de capteur structuré (2),
- application d'une couche d'isolation (27) sur le segment de capteur (2),
- réalisation de contacts traversants (39) dans la couche d'isolation (27),
- application d'un segment de couche de couverture (3) sur la couche d'isolation (27),
- enlèvement de la couche d'isolation (27),
- réalisation d'un volume intérieur de capteur (4), fermé hermétiquement entre le segment de capteur (2) et le segment de couche de couvercle (3) et
- intégration d'une installation électronique d'exploitation (30) au moins en partie dans le segment de couche de couvercle (3) raccordé par les contacts traversants (39) à une installation de commutation correspondante (20) du segment de capteur (2).

9. Procédé selon la revendication 8,
**caractérisé en ce que**
la fabrication du segment de recouvrement de couvercle (3), notamment sous la forme d'un segment de couche mince (3) sur le segment de capteur (2) est intégrée dans le procédé de fabrication d'un dispositif de capteur (1) en une seule pièce.

10. Procédé selon l'une des revendications 8 ou 9,
**caractérisé en ce que**
le segment de couche de couvercle (3) est réalisé de préférence en polysilicium ou en polysilicium-germanium.

11. Procédé selon l'une des revendications 8 à 10,
**caractérisé par**
une pression réduite par rapport à la pression atmosphérique dans le volume intérieur de capteur (4).

12. Procédé selon l'une des revendications 8 à 11,
**caractérisé en ce que**
l'installation électronique d'exploitation (30), intégrée au moins en partie dans le segment de couvercle (3) est prévue sur la surface supérieure (31) du segment de couvercle (3) à l'opposé du volume intérieur de capteur (4).

13. Procédé selon l'une des revendications 8 à 12,
**caractérisé en ce que**
la partie de l'installation électronique d'exploitation (30) intégrée dans le segment de couvercle (3) comporte un conditionnement de signal qui permet un couplage simple du dispositif de capteur (1) à des installations de circuits externes correspondants, par exemple des circuits CMOS.

14. Procédé selon l'une des revendications 8 à 13,
**caractérisé en ce que**
la liaison électrique des installations électroniques d'exploitation (30) du segment de couvercle (3) et de l'installation de commutation (20) du segment de capteur (2) est réalisée par au moins un contact traversant (32, 39) par exemple par une structure enfouie ou par des colonnes de silicium.
